(19) Europäisches Patentamt
European Patent Office
Office européen des brevets

(11) EP 4 604 697 A1

(12) # EUROPEAN PATENT APPLICATION
published in accordance with Art. 153(4) EPC

(43) Date of publication:
**20.08.2025 Bulletin 2025/34**

(21) Application number: **23950582.9**

(22) Date of filing: **29.12.2023**

(51) International Patent Classification (IPC):
***H10K 50/844*** *(2023.01)* ***H10K 50/84*** *(2023.01)*

(86) International application number:
**PCT/CN2023/143626**

(87) International publication number:
**WO 2025/044017 (06.03.2025 Gazette 2025/10)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **25.08.2023 CN 202311076295**

(71) Applicant: **Xi'an Smart Materials Co., Ltd.**
**Xi'an, Shaanxi 712099 (CN)**

(72) Inventors:
- **HE, Xin**
  **Xi'an, Shaanxi 712099 (CN)**
- **LEI, Ting**
  **Xi'an, Shaanxi 712099 (CN)**
- **LI, Yanfei**
  **Xi'an, Shaanxi 712099 (CN)**

(74) Representative: **Zacco GmbH**
**Bayerstrasse 83**
**80335 München (DE)**

(54) ## ENCAPSULATION STRUCTURE FOR ENCAPSULATING ORGANIC LIGHT-EMITTING DIODE

(57) Provided is a packaging structure for packaging an organic light emitting diode, which consists only of two layers, namely an organic barrier layer and an inorganic barrier layer. The organic barrier layer is in contact with the organic light emitting diode, and the inorganic barrier layer is attached above the organic barrier layer; the organic barrier layer is formed by a photocurable composition, and in parts by weight, the photocurable composition includes 5-20 parts by weight of a silicon-based photocurable monofunctional monomer, 30-50 parts by weight of a silicon-based photocurable bifunctional monomer, 20-60 parts by weight of a non-silicon-based photocurable monomer, and 1-10 parts by weight of a photoinitiator. The packaging structure of the present application has only two layers, meeting the development needs of an OLED device towards light weight, thin thickness, and low cost. At the same time, compared with the prior art, it can better suppress the erosion of moisture and/or oxygen on the OLED device, thus improving the reliability and service life of the OLED device.

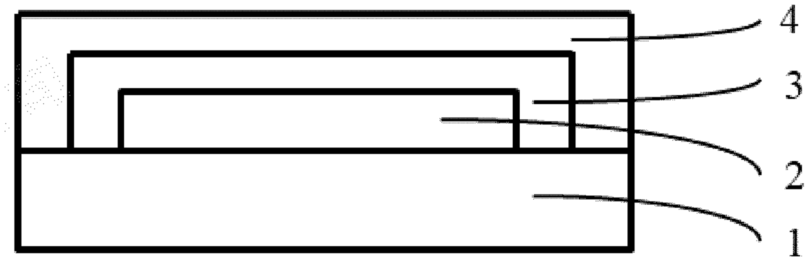


FIG. 1

EP 4 604 697 A1

## Description

### Cross-Reference to Related Application

The present application claims the priority to the Chinese patent application No. "2023110762956", titled "PACKAGING STRUCTURE FOR PACKAGING ORGANIC LIGHT EMITTING DIODE", filed to the Patent Office of the People's Republic of China on August 25, 2023, which is incorporated herein in its entirety by reference.

### Technical Field

The present application belongs to the technical field of electronic device packaging, and specifically relates to a packaging structure for packaging an organic light emitting diode.

### Background

Organic Light Emitting Diode (OLED for short) is an electroluminescent device that can convert electrical energy into visible light. Compared with a traditional LED light emitting diode, the OLED has the characteristics of active light emission, low driving voltage, high luminous efficiency, ultra-thinness and ultra-lightness, low cost, high response speed, and flexibility, and is expected to gradually become the mainstream of the next generation of display devices, which has attracted the attention of relevant research and development units.

At present, there are problems with the industrial development and application of a flexible OLED device, such as insufficient stability, and lack of reliability and service life. The main reason is that a material and a structure in the OLED device are sensitive to water vapor, oxygen, and heat, which can easily react with water vapor, oxygen, and other components in the air, leading to the failure of the OLED device. Therefore, strict packaging of the flexible OLED device is a necessary path to achieve mass production of the flexible OLED device. The current mainstream packaging method for the flexible OLED device is Barix packaging technology, which is an inorganic-organic overlapped multi-layer packaging structure that coats an organic layer on top of an inorganic layer, which can not only improve the defect of the inorganic layer, but also extend the path for the water vapor and the oxygen to enter the OLED device, improving high barrier performance.

In order to effectively inhibit moisture or oxygen from penetrating into the organic light emitting layer, the prior art usually sets up a multi-layer packaging structure due to limitations in a material and other factors. For example, the patent with the Chinese publication No. CN101859792A and titled "ORGANIC LIGHT EMITTING DIODE DISPLAY AND MANUFACTURING METHOD THEREOF" describes a packaging structure for packaging the OLED device that includes a 5-layer structure of a moisture absorption layer/first barrier layer/first auxiliary barrier layer/second barrier layer/second auxiliary barrier layer. Although the patent inhibits the erosion of moisture and/or oxygen on the OLED device to a certain extent through the 5-layer packaging structure, the excessive layer structure increases the weight and thickness of the device, and is not conducive to the development of the OLED device in the direction of simple, light and thin structure, process controllability and low cost.

In view of this, the present application provides a packaging structure for packaging an organic light emitting diode to solve the above-mentioned technical problem.

### Summary

An objective of the present application is to overcome the shortcomings of the above-mentioned prior art, and propose a packaging structure for packaging an organic light emitting diode. The packaging structure consists only of one organic barrier layer and one inorganic barrier layer, and the organic barrier layer is formed by irradiating a photocurable composition provided in the present application with ultraviolet light. An OLED device formed by this structure can better suppress the erosion of moisture and/or oxygen on the OLED device while meeting the development trend of light weight, thin thickness, and low cost, thus improving the reliability and service life of the OLED device.

To achieve the above-mentioned objective, the present application adopts the following technical solution:
The present application provides a packaging structure packaging an organic light emitting diode, the packaging structure consists of two layers, namely an organic barrier layer and an inorganic barrier layer, the organic barrier layer is formed by a photocurable composition, and an outgas amount of the organic barrier layer is <10 ppm, while a plasma etching rate is <7%;the organic barrier layer is in contact with the organic light emitting diode, and the inorganic barrier layer is attached above the organic barrier layer.

Furthermore, the photocurable composition includes the following components (A) to (D):

component (A): a silicon-based photocurable monofunctional monomer,

component (B): a silicon-based photocurable bifunctional monomer,

component (C): a non-silicon-based photocurable monomer, and

component (D): a photoinitiator;

the photocurable composition, in parts by weight, comprises 5-20 parts by weight of the silicon-based photocurable monofunctional monomer, 30-50 parts by weight of the silicon-based photocurable bifunctional monomer, 20-60 parts by weight of the non-silicon-based photocurable monomer, and 1-10 parts by weight of the photoinitiator.

Furthermore, the silicon-based photocurable monofunctional monomer is represented by structural formula (1):

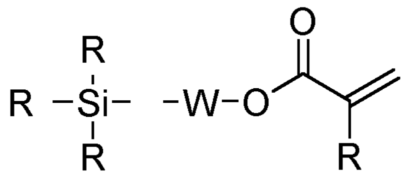

(1)

in the structural formula (1), $R_1$, $R_2$, and $R_3$ are selected from the group consisting of a substituted or unsubstituted C1-C20 alkyl group, a substituted or unsubstituted C1-C20 alkoxy group, a substituted or unsubstituted C3-C20 cycloalkyl group, a substituted or unsubstituted C6-C30 aryl group, a substituted or unsubstituted C3-C30 heteroaromatic group, or a substituted or unsubstituted C7-C30 arylalkyl group;

X is selected from the group consisting of a single bond, O, S, NH or NR', wherein R' is any one of a substituted or unsubstituted C1-C10 alkyl group, a substituted or unsubstituted C3-C10 cycloalkyl group, or a substituted or unsubstituted C1-C10 aryl group;

Y is selected from the group consisting of a substituted or unsubstituted C1-C20 alkylene group, a substituted or unsubstituted C1-C20 alkoxylene group, a substituted or unsubstituted C3-C20 cycloalkylene group, or a substituted or unsubstituted C6-C30 arylene group; and

R4 is a hydrogen or a methyl group.

Furthermore, the silicon-based photocurable bifunctional monomer is represented by structural formula (2):

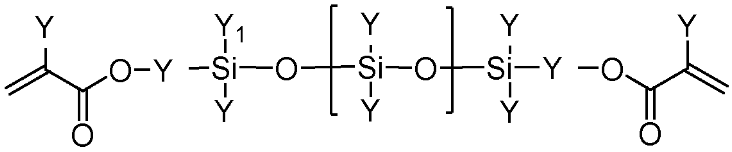

(2)

in the structural formula (2), Y1, Y2, Y3, Y4, Y5, and Y6 are selected from the group consisting of one of a hydrogen, a substituted or unsubstituted C1-C30 alkyl group, a substituted or unsubstituted C1-C20 alkyl group, a substituted or unsubstituted C1-C20 alkoxy group, a substituted or unsubstituted C3-C20 cycloalkyl group, a substituted or unsubstituted C6-C30 aryl group, a substituted or unsubstituted C3-C30 heteroaromatic group, or a substituted or unsubstituted C7-C30 arylalkyl group; and

preferably, the Y1, Y2, Y3, Y4, Y5, and Y6 contain substituted or unsubstituted C6-C30 aryl groups.

Y7 and Y8 are selected from the group consisting of a single bond, a substituted or unsubstituted C1-C20 alkylene group, a substituted or unsubstituted C1-C20 alkoxylene group, a substituted or unsubstituted C6-C30 arylene group, or a substituted or unsubstituted C7-C30 arylalkylene group; and

Y9 and Y10 are each independently a hydrogen or a methyl group.

Specifically, the silicon-based photocurable bifunctional monomer includes but is not limited to the following

structural formula:

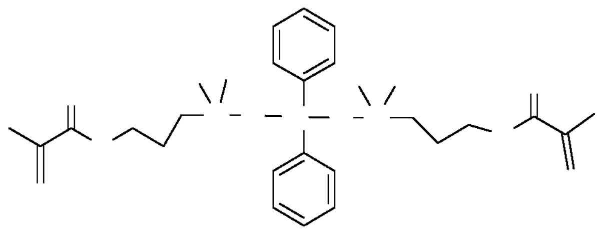

(2-1);

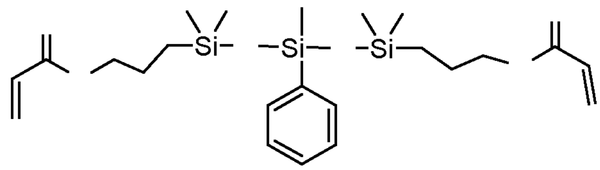

(2-2);

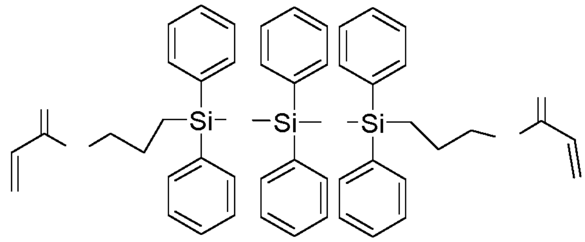

(2-3).

Furthermore, the non-silicon-based photocurable monomer does not contain silicon and has one or more photocurable functional groups.

Furthermore, the non-silicon-based photocurable monomer is a mixture of a monofunctional monomer and a multifunctional monomer, and a weight ratio of the monofunctional monomer to the multifunctional monomer is (1:0.1)-(1:10).

Furthermore, the monofunctional monomer is a mixture of at least two mono(methyl)acrylate monomers to optimize the inkjet printing performance and good leveling and film-forming properties of the photocurable composition.

The mono(methyl)acrylate monomer includes a cyclic mono(methyl)acrylate and/or an aliphatic mono(methyl) acrylate. A preferred viscosity for the cyclic mono(methyl)acrylate is ≤15 cps at 25°C, which may specifically include one or more of cyclohexyl methacrylate (1-5 cps at 25°C), isobornyl methacrylate (2-10 cps at 25°C), tetrahydrofurfurfuryl methacrylate (4-10 cps at 25°C), and 2-phenoxyethyl methacrylate (5-15 cps at 25°C); the cyclic mono(methyl)acrylate with a viscosity ≤15 cps at 25°C has excellent leveling and highly spreading properties, and can be cured on the organic light emitting diode to form an uniform and flat film. The aliphatic mono(methyl)acrylate includes a (methyl)acrylate containing branched or linear alkyl groups, specifically including any one of (methyl)methyl acrylate, (methyl)ethyl acrylate, (methyl)butyl acrylate, (methyl)2-hydroxyethyl acrylate, (methyl)2-hydroxybutyl acrylate, (methyl)hexyl acrylate, (methyl)octyl acrylate, (methyl)nonyl acrylate, (methyl)decyl acrylate, (methyl)undecyl acrylate, (methyl)dodecyl acrylate, etc.

Preferably, in order to balance the mechanical and plasma etching resistance properties of the photocurable composition, an amount of the monofunctional monomer added in the present application should not exceed 30% of the total mass of the photocurable composition.

Furthermore, the multifunctional monomer has at least three reactive (methyl)acrylate groups. Preferably, the multifunctional monomer is selected from the group consisting of tri(methyl)acrylate, tetra(methyl)acrylate, or a higher functional (methyl)acrylate. This type of multifunctional monomer can be used as a crosslinking agent to increase the crosslinking density of the photocurable composition.

Furthermore, the photoinitiator includes any typical photoradical initiator capable of inducing a photopolymerization reaction, specifically including one or more of a triazine initiator, an acetophenone initiator, a benzophenone initiator, a thioxanthenone initiator, a benzoin initiator, a phosphorus initiator, and an oxime initiator. The preferred photoinitiator used in the present application is a phosphorus initiator with a maximum absorption wavelength of 360 nm to 400 nm. The phosphorus initiator can effectively utilize long wavelength ultraviolet light to induce photocuring of the photocurable composition during irradiation. In addition, an amount of the photoinitiator added accounts for 1%-10% of the total mass of the photocurable composition. Within this range, under the irradiation of ultraviolet light, the photocuring

composition can undergo sufficient photopolymerization and prevent a decrease in transmittance caused by the remaining unreacted photoinitiator after photopolymerization.

When preparing the photocurable composition of the present application, the component (A) silicon-based photocurable monofunctional monomer, the component (B) silicon-based photocurable bifunctional monomer, the component (C) non-silicon-based photocurable monomer, and the component (D) photoinitiator are added to a brown opaque bottle in the above-mentioned proportions and mixed until uniform to obtain the photocurable composition. In addition, the photocurable composition of the present application does not contain any solvents, making it a solvent-free photocurable composition.

In summary, the present application provides a packaging structure consisting of an organic barrier layer and an inorganic barrier layer, wherein the organic barrier layer is in contact with the organic light emitting diode, the inorganic barrier layer is attached above the organic barrier layer, and the organic barrier layer is formed based on the above-mentioned photocurable composition. The outgas amount of the organic barrier layer is below 10 ppm, ensuring that during the evaporation process of the inorganic barrier layer, the amount of outgas released from the organic barrier layer is relatively small, and the flatness of the organic layer is high, achieving effective packaging of the organic light emitting diode.

Specifically, the organic barrier layer can be printed with a thickness of 1 $\mu$m to 15 $\mu$m by inkjet printing, and cured by UV irradiation for 1 second to 100 seconds at a power of 10 $mW/cm^2$ to 500 $mW/cm^2$. The photocurable composition of the present application has a viscosity of 15-45 cps and a surface tension of 20-38 mN/m at 25°C, demonstrating excellent inkjet printing performance; of course, the photocurable composition may further include a typical additive known in the relevant field, such as a heat stabilizer, an antioxidant, and an UV absorber, which will not be described in detail.

The organic barrier layer formed in the present application can achieve excellent plasma resistance. After actual testing, its plasma etching rate is below 7%, and it has low roughness to ensure excellent performance; at the same time, it has a lower water vapor transmission rate, and after actual testing, its water vapor transmission rate is below 3.0 $g/m^2 \cdot 24$ hrs. Therefore, it can prevent corrosion and deterioration of the luminous efficiency of the organic light emitting diode caused by external moisture and/or oxygen infiltration, and improve the reliability of the organic light emitting diode during operation time. In addition, a photocuring rate of the organic barrier layer is over 96%, and the glass transition temperature is above 100°C. The organic barrier layer fully meets the requirements of heat resistance, chemical resistance, dimensional stability, and long-term reliability, so it can effectively package the organic light emitting diode.

The inorganic barrier layer of the present application is formed from the same or different inorganic materials, which can be formed by sputtering, chemical vapor deposition, atomic layer deposition, particle beam assisted deposition of a metal oxide and a nitride; specifically, the inorganic materials of the inorganic barrier layer include silicon oxide ($SiO_X$), silicon nitride ($SiN_x$), silicon oxynitride ($SiO_xN_y$), ZnSe, ZnO, $Sb_2O_3$, $Al_2O_3$, etc., wherein x and y are each within the range of 1 to 5. Preferably, the thickness of the inorganic barrier layer is 1-1000 nm.

Compared with the prior art, the present application has the following advantageous effects:

A packaging structure for packaging an organic light emitting diode, which consists only of one organic barrier layer and one inorganic barrier layer, meeting the development needs of an organic light emitting device towards light weight, thin thickness, and low cost. In addition, the organic barrier layer formed by UV irradiation of the photocurable composition provided in the present application has lower plasma etching rate, lower water vapor transmission rate and lower outgas amount, and meanwhile has higher photocuring rate and higher glass transition temperature compared to the prior art, so that even a two-layer packaging structure can achieve stable and reliable packaging effect, protect a functional structure inside the organic light emitting diode from water vapor and oxygen erosion, and improve the reliability and service life of an OLED device, meet the stringent requirements for functional properties and packaging effects of an organic light emitting diode packaging material.

## Brief Description of the Drawings

The accompanying drawings are incorporated into the specification and form a part of it, together with the specification, for explaining the principles of the present application.

The drawings to be used in description of the embodiments or the prior art will be briefly introduced below in order to illustrate the technical solutions in the embodiments of the present application or the prior art more clearly. Apparently, for those skilled in the art, other drawings can be obtained according to these drawings without creative work.

FIG. 1 is a cross-sectional view of the organic light emitting diode device of the present application.

1 is a base substrate; 2 is an organic light emitting diode; 3 is an organic barrier layer; 4 is an inorganic barrier layer.

## Detailed Description of the Embodiments

Here, the exemplary embodiments will be described in detail, and the embodiments described in the following

exemplary embodiments do not represent all embodiments consistent with the present application. On the contrary, they are only examples of devices consistent with some aspects of the present application as described in the accompanying claims.

To enable a person skilled in the art to better understand the technical solution of the present application, the following provides a further detailed description of the present application in conjunction with the embodiments.

**Synthesis Example 1 (target product: a compound of formula 1-1)**

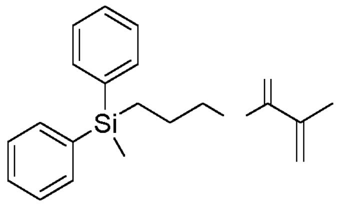

(1-1)

500 mL of ethyl acetate, 50 g of methyl(diphenyl)silane, and 80 g of allyl alcohol were added into a reactor, then replaced with nitrogen three times. 144 ppm of platinum-carbon black catalyst was added into the reactor, heated up to 80°C and stirred for 4 h, the remaining solvent was distilled off to obtain an intermediate product, and then the obtained 130 g of the intermediate product and 32 g of triethylamine were added into 500 of dichloromethane, cooled to 0°C, 30 g of methacryloyl chloride was slowly added, and the solvent was distilled off to obtain a compound represented by formula 1-1.

**Synthesis Example 2 (target product: a compound of formula 1-2)**

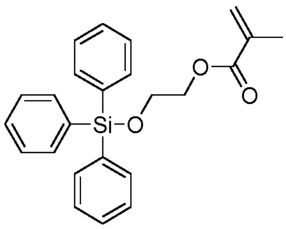

(1-2)

500 mL of dichloromethane, 50 g of 2-hydroxyethyl methacrylate, and 43.7 g of triethylamine were added into a reactor, then 87.4 g of triphenylchlorosilane was slowly added while stirring these components at 0°C, then heated up to 25°C and stirred for 4 h, and the remaining solvent was distilled off to obtain a compound represented by formula 1-2.

**Synthesis Example 3 (target product: a compound of formula 2-1)**

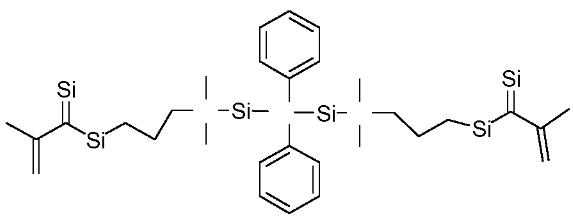

(2-1)

600 mL of ethyl acetate, 66.4 g of 3,3-diphenyl-1,1,5,5-tetramethyltrisiloxane (J&K Scientific), and 46.5 g of allyl alcohol were added into a reaction vessel, then nitrogen was introduced to replace three times, 200 ppm of platinum-carbon black powder was added to the mixture, heated up to 80°C, stirred for 4 h, the solvent was distilled off, and the obtained compound and 60.7 g of triethylamine were added to 400 mL of dichloromethane, then 50.2 g of methacryloyl chloride was slowly added while stirring the composition at 0°C, the remaining solvent was distilled off, and the compound

represented by formula 2-1 was obtained by column separation.

**Synthesis Example 4 (target product: a compound of formula 2-2)**

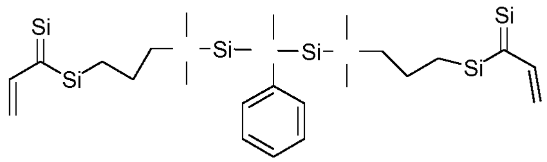

(2-2)

600 mL of ethyl acetate, 54.1 g of 3-phenyl-1,1,3,5,5-pentamethyltrisiloxane (J&K Scientific), and 46.5 g of allyl alcohol were added into a reaction vessel, then nitrogen was introduced to replace three times, 200 ppm of platinum-carbon black powder was added to the mixture, heated up to 80°C, stirred for 4 h, the solvent was distilled off, and the obtained compound and 60.7 g of triethylamine were added to 400 mL of dichloromethane, then 43.5 g of acryloyl chloride was slowly added while stirring the composition at 0°C, the remaining solvent was distilled off, and the compound represented by formula 2-2 was obtained by column separation.

**Synthesis Example 5 (target product: a compound of formula 2-4)**

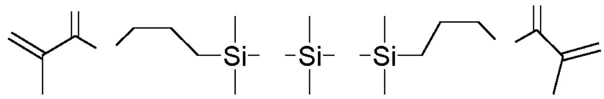

(2-4)

300 mL of ethyl acetate, 18 g of 1,1,3,3,5,5-hexamethyltrisiloxane, and 40 g of allyl alcohol were placed into a 1000 mL flask equipped with a cooling tube and a stirrer, and then purged with nitrogen for 30 minutes. Next, 72 ppm of Karstedt catalyst was added thereto, and then the flask was heated up to 80°C and the components were stirred for 4 hours, and the remaining solvent was distilled off to obtain a compound. 68.4 g of the obtained compound and 37 g of triethylamine were sequentially added to 300 mL of dichloromethane, and then 29.1 g of methacryloyl chloride was slowly added while slowly stirring the mixture at 0°C, and the remaining solvent was distilled off to obtain a target product represented by formula 2-4.

The detailed information of the components used in the examples and comparative examples is as follows:

(A) a silicon-based photocurable monofunctional monomer: (A1) a monomer represented by formula 1-1 (synthesis example 1), (A2) a monomer represented by formula 1-2 (synthesis example 2);

(B) a silicon-based photocurable bifunctional monomer: (B1) a monomer represented by formula 2-1 (synthesis example 3); (B2) a monomer represented by formula 2-2 (synthesis example 4); (B3) a monomer represented by 2-4 (synthesis example 5);

(C) a non-silicon-based photocurable monomer: (C1) isobornyl methacrylate; (C2) 2-phenoxyethyl methacrylate; (C3) dodecyl methacrylate; (C4) pentaerythritol tetraacrylate; and

(D) a photoinitiator: photoinitiator TPO.

**Example 1**

As shown in FIG. 1, the present example provides a packaging structure for packaging an organic light emitting diode, including an organic light emitting diode 2 disposed on a base substrate 1, the packaging structure is disposed on the organic light emitting diode 2 and covers the entire organic light emitting diode 2 in combination with the base substrate 1, the packaging structure consists of an organic barrier layer 3 and an inorganic barrier layer 4, the organic barrier layer 3 is in contact with the organic light emitting diode 2, and the inorganic barrier layer 4 is attached above the organic barrier layer 3.

The organic barrier layer 3 is formed of a photocurable composition. Specifically, in parts by weight, the

photocurable composition in the present example included 15 parts by weight of A1, 40 parts by weight of B1, 10 parts by weight of C1, 15 parts by weight of C3, 15 parts by weight of C4, and 5 parts by weight of D, which were placed in a 125 mL brown bottle and then mixed for 3 h using a shaker to prepare the photocurable composition.

**Example 2**

As shown in FIG. 1, the present example provides a packaging structure for packaging an organic light emitting diode, including an organic light emitting diode 2 disposed on a base substrate 1, the packaging structure is disposed on the organic light emitting diode 2 and covers the entire organic light emitting diode 2 in combination with the base substrate 1, the packaging structure consists of an organic barrier layer 3 and an inorganic barrier layer 4, the organic barrier layer 3 is in contact with the organic light emitting diode 2, and the inorganic barrier layer 4 is attached above the organic barrier layer 3.

The organic barrier layer 3 is formed of a photocurable composition. Specifically, in parts by weight, the photocurable composition in the present example included 20 parts by weight of A1, 35 parts by weight of B1, 10 parts by weight of C2, 15 parts by weight of C3, 15 parts by weight of C4, and 5 parts by weight of D, which were placed in a 125 mL brown bottle and then mixed for 3 h using a shaker to prepare the photocurable composition.

**Example 3**

As shown in FIG. 1, the present example provides a packaging structure for packaging an organic light emitting diode, including an organic light emitting diode 2 disposed on a base substrate 1, the packaging structure is disposed on the organic light emitting diode 2 and covers the entire organic light emitting diode 2 in combination with the base substrate 1, the packaging structure consists of an organic barrier layer 3 and an inorganic barrier layer 4, the organic barrier layer 3 is in contact with the organic light emitting diode 2, and the inorganic barrier layer 4 is attached above the organic barrier layer 3.

The organic barrier layer 3 is formed of a photocurable composition. Specifically, in parts by weight, the photocurable composition in the present example included 5 parts by weight of A2, 50 parts by weight of B2, 15 parts by weight of C1, 5 parts by weight of C3, 20 parts by weight of C4, and 5 parts by weight of D, which were placed in a 125 mL brown bottle and then mixed for 3 h using a shaker to prepare the photocurable composition.

**Example 4**

As shown in FIG. 1, the present example provides a packaging structure for packaging an organic light emitting diode, including an organic light emitting diode 2 disposed on a base substrate 1, the packaging structure is disposed on the organic light emitting diode 2 and covers the entire organic light emitting diode 2 in combination with the base substrate 1, the packaging structure consists of an organic barrier layer 3 and an inorganic barrier layer 4, the organic barrier layer 3 is in contact with the organic light emitting diode 2, and the inorganic barrier layer 4 is attached above the organic barrier layer 3.

The organic barrier layer 3 is formed of a photocurable composition. Specifically, in parts by weight, the photocurable composition in the present example included 15 parts by weight of A2, 40 parts by weight of B2, 10 parts by weight of C1, 10 parts by weight of C2, 5 parts by weight of C3, 5 parts by weight of C4, and 5 parts by weight of D, which were placed in a 125 mL brown bottle and then mixed for 3 h using a shaker to prepare the photocurable composition.

**Comparative Example 1**

The specific embodiment of Comparative Example 1 differs from that of Example 1 only in that the silicon-based photocurable bifunctional monomer B used in Comparative Example 1 is 40 parts by weight of B3, and the other components and the mixture ratio are exactly the same.

**Comparative Example 2**

The specific embodiment of Comparative Example 2 differs from that of Example 1 only in that the silicon-based photocurable bifunctional monomer B used in Comparative Example 2 is 55 parts by weight of B1, and the other components and the mixture ratio are exactly the same.

**Comparative Example 3**

The specific embodiment of Comparative Example 3 differs from that of Example 1 only in that the non-silicon-based photocurable monomer C used in Comparative Example 3 is only 30 parts by weight of C3 and 10 parts by weight of C4, and the other components and the mixture ratio are exactly the same.

To further verify the efficacy of the present application, the inventors conducted the following related tests on the organic barrier layer (photocurable composition) obtained from Examples 1-4 and Comparative Examples 1-3:

Performance tests:

(1) Outgas amount: the photocurable composition was inkjet-printed on a glass substrate and UV-cured for 30 seconds by UV irradiation at 150 $mJ/cm^2$. The cured sample was peeled off and cut into a thin strip (8 mm x 55 mm), and attached to the inner wall of a 20 mL empty headspace bottle. The sample weighed about 0.1 g. The outgas was measured using a gas chromatography-mass spectrometry (Thermo Fisher TRACE 1300). The gas chromatography-mass spectrometry used an Agilent HP-5MS UI column (length: 30 m, diameter: 0.25 mm, stationary phase thickness: 0.25 $\mu$m) as a chromatographic column, and helium was used as the mobile phase at a split ratio of 17:1. The temperature program was set as follows: 35°C for 2 min, increased to 200°C at 8°C/min, increased to 300°C at 20°C/min, and held for 10 min. The outgas was collected at a collection temperature of 110°C for 30 min under He gas purge at a flow rate of 200 mL/min, with 5% phenylmethylpolysiloxane as an adsorbent. An NMP solution of acetone at concentrations of 6 ppm, 8 ppm, 10 ppm, 12 ppm, and 14 ppm was used as a standard solution to draw a calibration curve, with an $R^2$ value of 0.9991.

(2) Plasma etching rate: a composition for OLED thin film packaging was coated on a silicon wafer and photocured to form an organic layer, and then the initial coating height ($T_1$, unit: $\mu$m) of the organic layer was measured. The organic barrier layer was treated with plasma under the conditions of ICP power: 2500 W; RE power: 300 W; DC bias voltage: 200 V; Ar flow rate: 50 sccm; etching time: 1 minute; pressure: 10 mTorr, and then the height ($T_2$, unit: $\mu$m) of the organic layer was measured. The plasma etching rate of the organic layer was calculated by the following equation:

$$\text{Plasma etching rate (\%)} = (T_1-T_2)/T_1 \times 100\%$$

wherein $T_1$ is the initial height of the organic layer, and $T_2$ is the height of the organic layer after plasma treatment.

(3) Photocuring rate: the absorption peak intensity of a glue before curing and a film after curing at 1635 $cm^{-1}$ (C=C) and 1720 $cm^{-1}$ (C=O) were measured using FT-IR (Bruker INVENIO).

$$\text{Curing rate (\%)} = |1-(C_1/C_0)| \times 100\%;$$

$C_1$ is the ratio of the absorption peak intensity near 1635 $cm^{-1}$ to the absorption peak intensity near 1720 $cm^{-1}$ of the cured film; and $C_0$ is the ratio of the absorption peak intensity near 1635 $cm^{-1}$ to the absorption peak intensity near 1720 $cm^{-1}$ of the uncured ink.

(4) Glass transition temperature (Tg): the prepared photocurable composition was inkjet printed on a glass substrate and subjected to UV curing by UV irradiation for 60 s at 30 $mW/cm^2$ to prepare a sample having a size of 5 cm x 5 cm x 1 mm (width x length x thickness), and then tested using a differential scanning calorimeter (DSC), test conditions: test atmosphere $N_2/O_2$; test temperature range: -180°C to 550°C; heating rate: 10°C/min.

(5) Water vapor transmission rate: the prepared photocurable composition was inkjet printed on a glass substrate and subjected to UV curing by UV irradiation for 60 s at 30 $mW/cm^2$ to prepare a sample having a size of 5 cm x 5 cm x 1 mm (width x length x thickness), and then the water vapor transmission rate was measured using a water vapor transmission rate tester (PERMATRAN-W3/33, manufactured by MOCON) at 85°C and 85% relative humidity for 24 hours.

(6) Film thickness uniformity: coating was performed on a 6-inch ordinary glass at a speed of 500 r/min on a glue uniformizing machine, the spin-coated film was irradiated under a UV lamp for 30 s, then 30 points were uniformly selected on an ellipsometer for film thickness measurement, and after the thicknesses of the 30 points were measured, the film thickness uniformity was calculated using the following formula.

Film thickness uniformity = (maximum film thickness - minimum film thickness)/(maximum film thickness + minimum film thickness) * 100%;

(7) Leveling property: one drop ink was printed on an inkjet printer, leveling was performed for 120 s, and the ink drop leveling diameter (μm) was observed;

Performance test results: as shown in Table 1 below:

Table 1

| Unit: parts by weight | | Examples | | | | Comparative examples | | |
|---|---|---|---|---|---|---|---|---|
| | | 1 | 2 | 3 | 4 | 1 | 2 | 3 |
| A | A1 | 15 | 20 | - | - | 15 | - | 15 |
| | A2 | - | - | 5 | 15 | - | - | - |
| B | B1 | 40 | 35 | - | - | - | 55 | 40 |
| | B2 | - | - | 50 | 40 | - | - | - |
| | B3 | - | - | - | - | 40 | - | - |
| C | C1 | 10 | - | 15 | 10 | 10 | 10 | - |
| | C2 | - | 10 | - | 10 | - | - | - |
| | C3 | 15 | 15 | 5 | 5 | 15 | 15 | 30 |
| | C4 | 15 | 15 | 20 | 5 | 15 | 15 | 10 |
| D | | 5 | 5 | 5 | 5 | 5 | 5 | 5 |
| Outgas (ppm) | | 3.31 | 4.59 | 4.16 | 3.79 | 15.4 | 16.8 | 13.8 |
| Plasma etching rate (%) | | 5.8 | 6.1 | 5.1 | 6.8 | 17.4 | 14.8 | 12.5 |
| Photocuring rate (%) | | 97.1 | 98.2 | 97.6 | 97.9 | 95.8 | 93.6 | 92.5 |
| Glass transition temperature (°C) | | 109 | 106 | 103 | 112 | 84 | 91 | 103 |
| Water vapor transmission rate ($g/m^2 \cdot 24$ hrs) | | 2.5 | 2.4 | 2.9 | 2.8 | 4.6 | 6.1 | 5.8 |
| Film thickness uniformity (%) | | 2.4 | 3.1 | 3.1 | 2.8 | 4.5 | 5.6 | 6.8 |
| Leveling property (μm) | | 190 | 210 | 230 | 250 | 290 | 150 | 130 |

As can be seen from the data in Table 1, the cured film layer (organic barrier layer) obtained by using the photocurable composition of the present application has the following properties: outgas < 5 ppm, plasma etching rate < 7%, photocuring rate > 97, glass transition temperature ≥ 103°C, water vapor transmission rate < 3 $g/m^2 \cdot 24$ hrs, film thickness uniformity < 3.2%, and leveling property is maintained in the range of 180 μm-260 μm, that is, the organic barrier layer obtained by the present application has excellent performance, therefore, the two-layer packaging structure formed by the organic barrier layer and the inorganic barrier layer not only has the advantages of light weight, thin thickness and low cost, but also has lower plasma etching rate, lower water vapor transmission rate and lower outgas amount, and meanwhile has higher photocuring rate and higher glass transition temperature. Therefore, adopting this packaging structure can significantly improve the reliability and service life of the OLED device.

The above description is merely specific embodiments of the present application and enables those skilled in the art to understand or implement the present application. Various modifications to these embodiments will be apparent to those skilled in the art, and the general principles defined herein can be implemented in other embodiments without departing from the spirit or scope of the present application.

It should be understood that the present application is not limited to the content already described above, and various modifications and changes can be made without departing from the scope of the present application. The scope of the present application is limited only by the appended claims.

## Claims

1. A packaging structure for packaging an organic light emitting diode, wherein the packaging structure consists of two layers, namely an organic barrier layer (3) and an inorganic barrier layer (4), the organic barrier layer (3) is formed by a photocurable composition, and an outgas amount of the organic barrier layer (3) is <10 ppm, while a plasma etching rate is <7%;
the organic barrier layer (3) is in contact with the organic light emitting diode (2), and the inorganic barrier layer (4) is attached above the organic barrier layer (3).

2. The package structure for packaging the organic light emitting diode according to claim 1, wherein the photocurable composition comprises the following components (A) to (D):

component (A): a silicon-based photocurable monofunctional monomer,
component (B): a silicon-based photocurable bifunctional monomer,
component (C): a non-silicon-based photocurable monomer, and
component (D): a photoinitiator;
the photocurable composition, in parts by weight, comprises 5-20 parts by weight of the silicon-based photocurable monofunctional monomer, 30-50 parts by weight of the silicon-based photocurable bifunctional monomer, 20-60 parts by weight of the non-silicon-based photocurable monomer, and 1-10 parts by weight of the photoinitiator.

3. The packaging structure for packaging the organic light emitting diode according to claim 2, wherein the silicon-based photocurable monofunctional monomer is represented by structural formula (1):

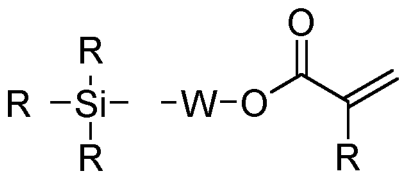

(1)

in the structural formula (1), $R_1$, $R_2$, and $R_3$ are selected from the group consisting of a substituted or unsubstituted C1-C20 alkyl group, a substituted or unsubstituted C1-C20 alkoxy group, a substituted or unsubstituted C3-C20 cycloalkyl group, a substituted or unsubstituted C6-C30 aryl group, a substituted or unsubstituted C3-C30 heteroaromatic group, or a substituted or unsubstituted C7-C30 arylalkyl group;
X is selected from the group consisting of a single bond, O, S, NH or NR', wherein R' is any one of a substituted or unsubstituted C1-C10 alkyl group, a substituted or unsubstituted C3-C10 cycloalkyl group, or a substituted or unsubstituted C1-C10 aryl group;
Y is selected from the group consisting of a substituted or unsubstituted C1-C20 alkylene group, a substituted or unsubstituted C1-C20 alkoxylene group, a substituted or unsubstituted C3-C20 cycloalkylene group, or a substituted or unsubstituted C6-C30 arylene group; and
R4 is a hydrogen or a methyl group.

4. The packaging structure for packaging the organic light emitting diode according to claim 2, wherein the silicon-based photocurable bifunctional monomer is represented by structural formula (2):

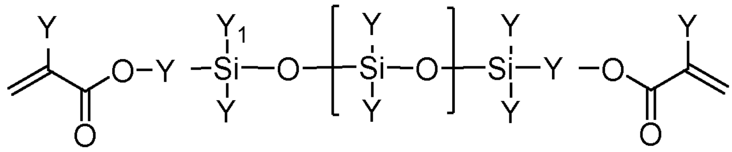

(2)

in the structural formula (2), Y1, Y2, Y3, Y4, Y5, and Y6 are selected from the group consisting of a hydrogen, a substituted or unsubstituted C1-C30 alkyl group, a substituted or unsubstituted C1-C20 alkyl group, a substituted or unsubstituted C1-C20 alkoxy group, a substituted or unsubstituted C3-C20 cycloalkyl group, a substituted or unsubstituted C6-C30 aryl group, a substituted or unsubstituted C3-C30 heteroaromatic group, or a substituted or unsubstituted C7-C30 arylalkyl group;

Y7 and Y8 are selected from the group consisting of a single bond, a substituted or unsubstituted C1-C20 alkylene group, a substituted or unsubstituted C1-C20 alkoxylene group, a substituted or unsubstituted C6-C30 arylene group, or a substituted or unsubstituted C7-C30 arylalkylene group; and
Y9 and Y10 are each independently a hydrogen or a methyl group.

**5.** The packaging structure for packaging the organic light emitting diode according to claim 2, wherein the non-silicon-based photocurable monomer is a mixture of a monofunctional monomer and a multifunctional monomer, and a weight ratio of the two is (1:0.1)-(1:10).

**6.** The packaging structure for packaging the organic light emitting diode according to claim 5, wherein the monofunctional monomer is a mixture formed by at least two mono(methyl)acrylate monomers.

**7.** The packaging structure for packaging the organic light emitting diode according to claim 6, wherein the mono(methyl) acrylate monomer is a cyclic mono(methyl)acrylate and/or an aliphatic mono(methyl)acrylate.

**8.** The packaging structure for packaging the organic light emitting diode according to claim 5, wherein the multifunctional monomer has at least three reactive (methyl)acrylate groups.

**9.** The packaging structure for packaging the organic light emitting diode according to claim 8, wherein the multifunctional monomer is selected from the group consisting of tri(methyl)acrylate, tetra(methyl)acrylate, and a higher functional (methyl)acrylate.

**10.** The packaging structure for packaging the organic light emitting diode according to claim 2, wherein the photoinitiator is selected from the group consisting of a triazine initiator, an acetophenone initiator, a benzophenone initiator, a thioxanthenone initiator, a benzoin initiator, a phosphorus initiator, and an oxime initiator.

**11.** The packaging structure for packaging the organic light emitting diode according to claim 5, wherein an amount of the monofunctional monomer added does not exceed 30% of the total mass of the photocurable composition.

**12.** The packaging structure for packaging the organic light emitting diode according to claim 7, wherein a viscosity of the cyclic mono(methyl)acrylate is ≤15 cps at 25°C.

**13.** The packaging structure for packaging the organic light emitting diode according to claim 2, wherein an amount of the photoinitiator added accounts for 1%-10% of the total mass of the photocurable composition.

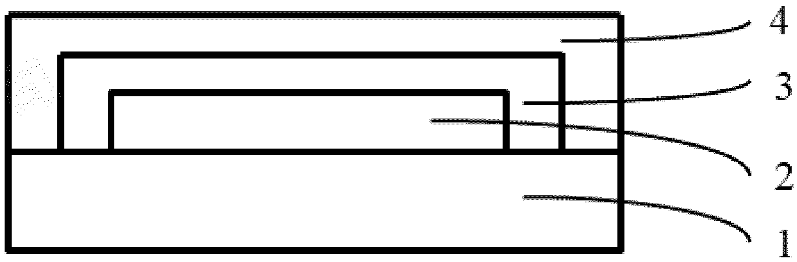


FIG. 1

**INTERNATIONAL SEARCH REPORT**

International application No.
**PCT/CN2023/143626**

**A. CLASSIFICATION OF SUBJECT MATTER**

H10K50/844(2023.01)i；H10K50/84(2023.01)i

According to International Patent Classification (IPC) or to both national classification and IPC

**B. FIELDS SEARCHED**

Minimum documentation searched (classification system followed by classification symbols)

IPC: H10K, H01L

Documentation searched other than minimum documentation to the extent that such documents are included in the fields searched

Electronic data base consulted during the international search (name of data base and, where practicable, search terms used)

CNTXT, ENTXT, DWPI, ENTXTC, WPABS, CNKI: 有机发光, 电致发光, 电激发光, 场致发光, 电光器件, OLED, 封装, 有机, 无机, 阻挡, 层, 硅, 单官能, 单体, 双官能, 光??引发剂, organic light-emitting diode, organic LED, EL, electroluminescen+, packag+, encapsulat+, capsulation, seal+, organic, inorganic, barrier, layer, silicon, monofunctional, monomer, bifunctional, photoinitiator

**C. DOCUMENTS CONSIDERED TO BE RELEVANT**

| Category* | Citation of document, with indication, where appropriate, of the relevant passages | Relevant to claim No. |
|---|---|---|
| PX | CN 117119825 A (XI'AN SIMOWEI NEW MATERIAL CO., LTD.) 24 November 2023 (2023-11-24)<br>description, paragraphs 0008-0106, and figure 1 | 1-13 |
| Y | CN 107068896 A (TIANMA MICRO-ELECTRONICS CO., LTD. et al.) 18 August 2017 (2017-08-18)<br>description, paragraphs 0037-0157, and figures 2-4 | 1-13 |
| Y | CN 115960490 A (XI'AN SIMOWEI NEW MATERIAL CO., LTD.) 14 April 2023 (2023-04-14)<br>description, paragraphs 0006-0113 | 1-13 |
| Y | CN 108137755 A (SAMSUNG SDI CO., LTD.) 08 June 2018 (2018-06-08)<br>description, paragraphs 0026-0201, and figures 1-2 | 1-13 |
| A | CN 101859792 A (SAMSUNG MOBILE DISPLAY CO., LTD.) 13 October 2010 (2010-10-13)<br>entire document | 1-13 |

☑ Further documents are listed in the continuation of Box C. ☑ See patent family annex.

* Special categories of cited documents:
- "A" document defining the general state of the art which is not considered to be of particular relevance
- "D" document cited by the applicant in the international application
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| **18 April 2024** | **25 April 2024** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | <br>Telephone No. |

Form PCT/ISA/210 (second sheet) (July 2022)

**INTERNATIONAL SEARCH REPORT**

International application No.
**PCT/CN2023/143626**

**C. DOCUMENTS CONSIDERED TO BE RELEVANT**

| Category* | Citation of document, with indication, where appropriate, of the relevant passages | Relevant to claim No. |
|---|---|---|
| A | WO 2017039228 A1 (SAMSUNG SDI CO., LTD.) 09 March 2017 (2017-03-09)<br>entire document | 1-13 |

Form PCT/ISA/210 (second sheet) (July 2022)

**INTERNATIONAL SEARCH REPORT**
**Information on patent family members**

International application No.
**PCT/CN2023/143626**

| Patent document cited in search report | | | Publication date (day/month/year) | Patent family member(s) | | | Publication date (day/month/year) |
|---|---|---|---|---|---|---|---|
| CN | 117119825 | A | 24 November 2023 | None | | | |
| CN | 107068896 | A | 18 August 2017 | None | | | |
| CN | 115960490 | A | 14 April 2023 | None | | | |
| CN | 108137755 | A | 08 June 2018 | None | | | |
| CN | 101859792 | A | 13 October 2010 | CN | 101859792 | B | 04 July 2012 |
| WO | 2017039228 | A1 | 09 March 2017 | None | | | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- CN 2023110762956
- CN 101859792 A